# EUROPEAN PATENT APPLICATION

(11) **EP 2 226 305 A1**
(43) Date of publication of application: **08.09.2010**
(21) Application number: 08868954.2
(22) Date of filing: 17.12.2008
(51) Int. Cl.: C03C 17/34

(54) **HEAT REFLECTING GLASS AND PROCESS FOR PRODUCING HEAT REFLECTING GLASS**

(30) Priority: 27.12.2007 JP 2007336133
(71) Applicant: Asahi Glass Company, Limited, Chiyoda-ku Tokyo 100-8405 (JP)
(72) Inventor: YAOITA, Kazuya, Tokyo 100-8405 (JP); KATAYAMA, Yoshihito, Tokyo 100-8405 (JP)
(74) Representative: Müller-Boré & Partner Patentanwälte
(86) International application number: PCT/JP2008/073013
(87) International publication number: WO 2009/084442

(57) **Abstract**

To provide a heat reflecting glass provided with at least a chromium nitride film, which has a visible light transmittance Tᵥ of at most 35% and a solar transmittance Tₑ/visible light transmittance Tᵥ ratio of less than 1.0 and which undergoes substantially no change in the optical properties even when subjected to heat treatment for strengthening or bending. An oxygen-blocking undercoat film made of silicon nitride is formed on the surface of a glass substrate; a chromium nitride film for heat reflection is formed as an upper layer of the oxygen-blocking undercoat film; and further, an oxygen-blocking protective film made of silicon nitride is formed as an upper layer of the chromium nitride film. The ratio in the number of atoms of nitrogen to chromium in the chromium nitride for heat reflection is from 20% to 60%.

## Description

### TECHNICAL FIELD

The present invention relates to a heat reflecting glass having at least a chromium nitride film formed on a glass substrate. Particularly, it relates to a heat reflecting glass having a thin film formed on the surface of a glass substrate for the main purpose of blocking solar radiation heat, and a process for producing such a heat reflecting glass.

### BACKGROUND ART

At present, a heat reflecting glass having a thin film formed on the surface of a glass substrate for the main purpose of blocking solar radiation heat, is used for e.g. a window of architectural structures such as buildings, or as a rear glass for vehicles. From a viewpoint of a light transmitting property of such a heat reflecting glass, a demand for a heat reflecting glass having a low transmittance is also increasing. In a case where a glass is used for a window of architectural structures such as buildings, depending upon the site where the glass is to be installed, strengthening treatment is required, or it is preferred to install a strengthened glass. Whereas, a rear glass for vehicles is not a plate form having a flat surface, but is a plate form having a curved surface, and a heat reflecting glass subjected to bending treatment is employed.

In order to obtain a heat reflecting glass subjected to strengthening treatment or bending treatment, a method may be mentioned wherein a thin film having a heat reflection property is formed on a glass substrate subjected to strengthening treatment or bending treatment. However, it is difficult to form a heat reflecting thin film with good precision on e.g. the surface of a glass substrate subjected to bending treatment i.e. on the glass substrate surface having a curvature, so that the film thickness and the in-plane distribution of the composition become good. In order to form a heat reflecting thin film on a glass substrate surface having a curvature so that the film thickness and the in-plane distribution of the composition become good, it is necessary to adjust e.g. the thin film-forming step or the thin film-forming conditions to meet the curvature of the glass substrate surface, and thus an extra cost will be required.

On the other hand, in order to carry out bending treatment of a glass substrate having a heat reflecting thin film preliminarily formed, it is necessary e.g. to heat the glass substrate to a high temperature at a level of from 500 to 700°C. A conventional heat reflecting glass has had a problem that at such a high temperature, the heat reflecting thin film may for example be oxidized, and the heat reflecting performance may change between before and after the heating. Therefore, with such a conventional heat reflecting glass, it has been difficult for the glass processing dealer who purchased the glass having a heat reflecting thin film preliminarily formed, to carry out the bending. For example, in a case where the glass processing dealer carries out the bending by himself, in order to prevent a change in the heat reflecting performance between before and after the heating, the glass processing dealer himself is required to carry out the bending while maintaining the atmosphere during the bending to be a non-oxidizing atmosphere to prevent oxidation of the film to be protected. In such a case, a special apparatus or time and efforts will be required, and the resulting cost will be substantial. Therefore, a demand for a flat plate-form heat reflecting glass is substantial whereby strengthening treatment or bending treatment can be carried out by the glass processing dealer himself without requiring an extra time and efforts or a special apparatus having a function to keep the atmosphere during the bending to be a non-oxidizing atmosphere.

Whereas, the following Patent Document 1 discloses a process for producing a heat-treated heat reflecting glass (heat reflecting glass). In the process disclosed in Patent Document 1, a heat ray-blocking film or an electroconductive film is formed on a glass substrate, and then, a first protective film transparent in a visible light region is formed to obtain a heat reflecting glass having a multilayer film composed of at least two layers, and then, heat treatment is applied to such a heat reflecting glass. This process for producing a heat reflecting glass is **characterized in that** the first protective film is made of a film containing, as its main component, a nitride of silicon or boron, or nitrides of at least two types selected from silicon, boron, aluminum, zirconium and tin. The Patent Document 1 discloses that in the heat reflecting glass disclosed in Patent Document 1, the first protective film serves as an oxygen barrier by sufficiently absorbing oxygen entering from the atmosphere during the heat treatment, whereby the heat ray-blocking film undergoes no substantial change. That is, the Patent Document 1 discloses that with the heat reflecting glass prepared by the process for producing a heat reflecting glass disclosed in Patent Document 1, there is no substantial change in e.g. the optical properties of the coating layer to be protected, even if bending treatment or strengthening treatment is carried out by a simple method commonly employed (in the atmosphere without controlling the atmosphere).
Patent Document 1: Japanese Patent No. 2,518,129

### DISCLOSURE OF THE INVENTION

### OBJECT TO BE ACCOMPLISHED BY THE INVENTION

A heat reflecting glass to be used for architectural structures such as buildings is required not only to be of a low price but also to have a proper balance of the optical properties and the thermal properties. In the present invention, the optical properties and the thermal properties will be together referred to as optical properties. The optical properties may, for example, be a nature relating to glare felt by a person in a room in e.g. a building, or a privacy nature such as inside not being seen from outside, and a nature relating to the degree of transmittance of a wavelength component mainly in a visible light region. Such a nature may be represented by a visible light transmittance defined in JIS R-3106 (1998). Whereas, the thermal properties is a nature relating to the amount of heat entering into a room in e.g. a building by sunlight, and a nature relating to the degree of transmittance of a wavelength component mainly in a near infrared region of sunlight. Such a nature may be represented by a solar transmittance defined in JIS R-3106 (1998).

Particularly, a heat reflecting glass which has a visible light transmittance Tᵥ of at most 35% and a solar transmittance Tₑ/visible light transmittance Tᵥ ratio of less than 1.0 with respect to the visible light transmittance and solar transmittance as defined above and of which the optical properties undergo no substantial change even when heat treatment is applied for strengthening or bending, is practically excellent and is demanded also by the market.

It has been confirmed by the present inventors that by Examples disclosed in Patent Document 1, the ratio of the solar transmittance to the visible light transmittance cannot be made sufficiently low as compared with heretofore. The heat reflecting glass prepared by the process disclosed in Patent Document 1 cannot satisfy all of the demands by the market in recent years. Particularly, in Southeast Asian areas or areas right on the equator where insolation is intense and day time sunlight is dazzling, one having a low solar transmittance in a state of a low visible light transmittance is especially desired.

The present invention has an object to solve such problems. That is, it is an object of the present invention to provide a heat reflecting glass which has a visible light transmittance Tᵥ of at most 35% and a solar transmittance Tₑ/visible light transmittance Tᵥ ratio of less than 1.0 and of which the optical properties undergo no substantial change even if a heat treatment is applied for strengthening or bending.

### MEANS TO ACCOMPLISH THE OBJECT

In order to accomplish the above object, the present invention provides a heat reflecting glass comprising a glass substrate, and an oxygen-blocking undercoat film, a chromium nitride film and an oxygen-blocking protective film formed in this order on the glass substrate, wherein in the chromium nitride film, the ratio in the number of atoms of nitrogen to chromium (i.e. the number of nitrogen atoms/the number of chromium atoms) is from 20% to 60%.

Here, each of the oxygen-blocking undercoat film and the oxygen-blocking protective film, is preferably a film containing, as its main component, a nitride of silicon or boron, or a film containing, as its main components, nitrides of at least two elements selected from the group consisting of silicon, boron, aluminum, zirconium and tin.

Further, it is preferred that the visible light transmittance is at most 35% as defined in JIS R-3106 (1998) and the ratio of its solar transmittance as defined in JIS R-3106 (1998) to the visible light transmittance (i.e. the solar transmittance/the visible light transmittance) is less than 1.0. At that time, it is preferred that the heat reflecting glass has been subjected to heat treatment at a temperature of at least 500°C.

Further, the film thickness of the oxygen-blocking undercoat film is preferably from 5 to 20 nm, and the thickness of the oxygen-blocking protective film is preferably from 10 to 30 nm.

Further, the heat reflecting glass preferably has an impurity-blocking undercoat film to prevent migration of impurities contained in the glass substrate, between the glass substrate and the oxygen-blocking undercoat film.

Further, the present invention provides a process for producing a heat reflecting glass comprising a glass substrate, and an oxygen-blocking undercoat film, a chromium nitride film and an oxygen-blocking protective film formed in this order on the glass substrate, which comprises:
a step of introducing a glass substrate into a film deposition chamber, and sputtering a chromium target in a nitrogen-containing atmosphere in the chamber to form a chromium nitride film on the glass substrate, and
a step of supplying not only nitrogen gas but also an inert gas other than the nitrogen gas into the chamber during the sputtering, and adjusting the ratio of the amount of the inert gas supplied to be within a range of (the inert gas:the nitrogen gas)=(70:30) to (90:10).

Further, the process preferably has:
a step of forming, prior to the sputtering, an oxygen-blocking undercoat film being a film containing, as its main component, a nitride of silicon or boron, or a film containing, as its main components, nitrides of at least two elements selected from the group consisting of silicon, boron, aluminum, zirconium and tin, on the glass substrate, and
a step of forming, after the sputtering, an oxygen-blocking protective film being a film containing, as its main component, a nitride of silicon or boron, or a film containing, as its main components, nitrides of at least two elements selected from the group consisting of silicon, boron, aluminum, zirconium and tin, on the surface of the chromium nitride film.

Further, the process preferably includes heat treatment at a temperature of at least 500°C after forming the oxygen-blocking undercoat film, the chromium nitride film and the oxygen-blocking protective film.

### ADVANTAGEOUS EFFECTS OF THE INVENTION

According to the present invention, it is possible to provide, for example, a heat reflecting glass which has a visible light transmittance Tᵥ of at most 35% and a solar transmittance Tₑ/visible light transmittance Tᵥ ratio of less than 1.0 and of which the optical properties undergo substantially no change even if heat treatment is applied for strengthening or bending.

In other words, it is possible to provide a heat reflecting glass which can be heat-treated and of which the visible light transmittance Tᵥ is sufficiently low to prevent glare felt by a person in a room in e.g. a building and to provide a privacy nature such that the inside is not seen from outside, and the solar transmittance Tₑ/visible light transmittance Tᵥ ratio is as low as less than 1.0 thereby to satisfy a performance to prevent heat from entering into the room.

### BRIEF DESCRIPTION OF THE DRAWINGS

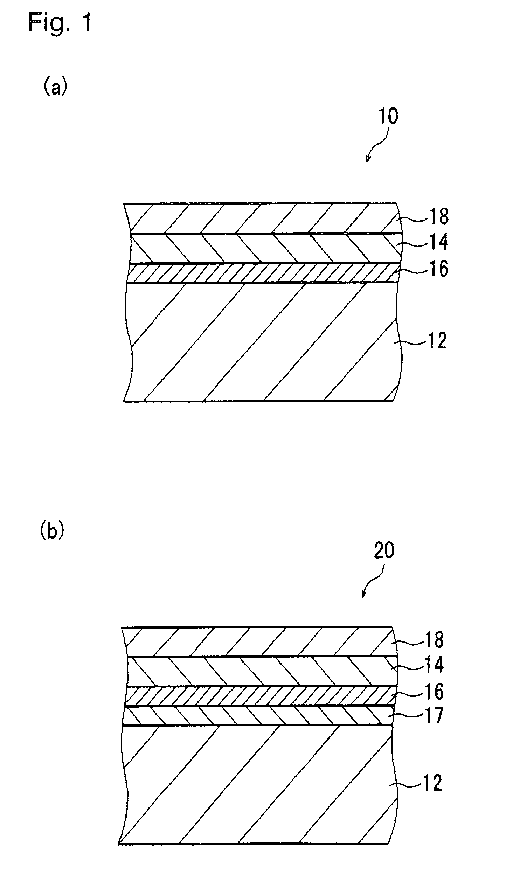

Figs. 1 (a) and 1 (b) are schematic cross-sectional views illustrating different embodiments of the heat reflecting glass of the present invention.

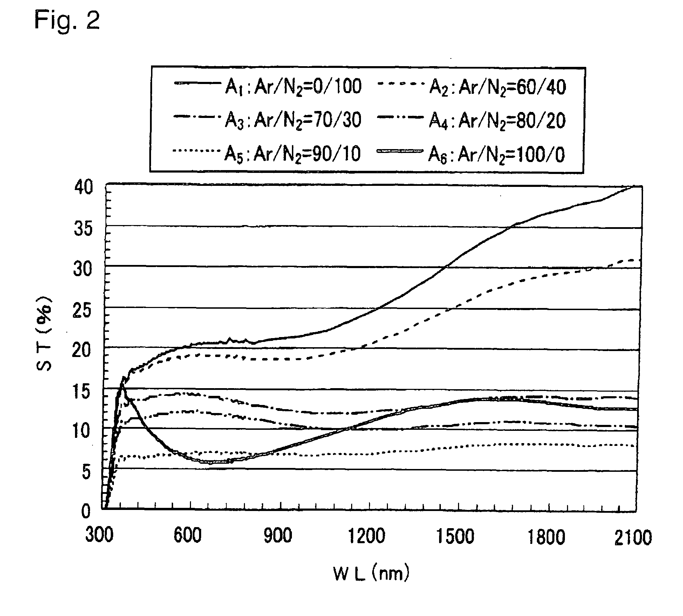

Fig. 2 is a graph showing spectra of spectral transmittances of chromium nitride single films formed under different film deposition conditions. The abscissa axis represents the wavelength (WL), and the ordinate axis represents the spectral transmittance (ST).

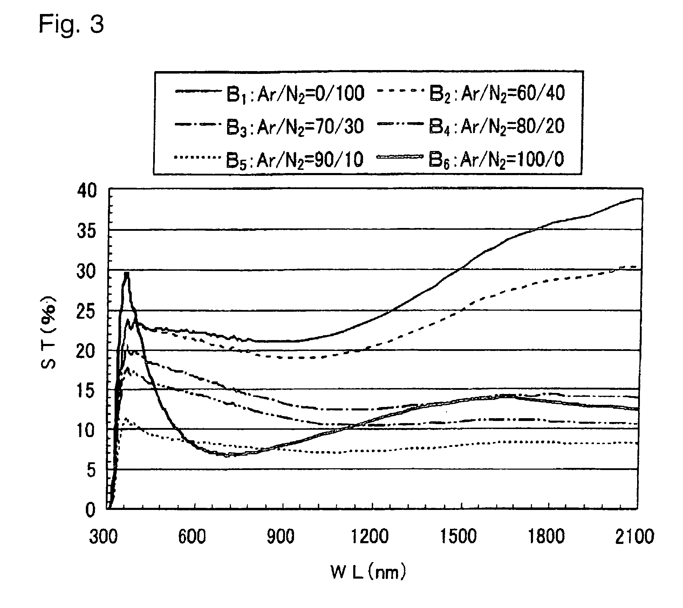

Fig. 3 is a graph showing spectra of spectral transmittances of samples wherein an oxygen-blocking undercoat film/a chromium nitride film formed under a different film deposition condition/an oxygen-blocking protective film are laminated on a glass substrate. The abscissa axis represents the wavelength (WL), and the ordinate axis represents the spectral transmittance (ST).

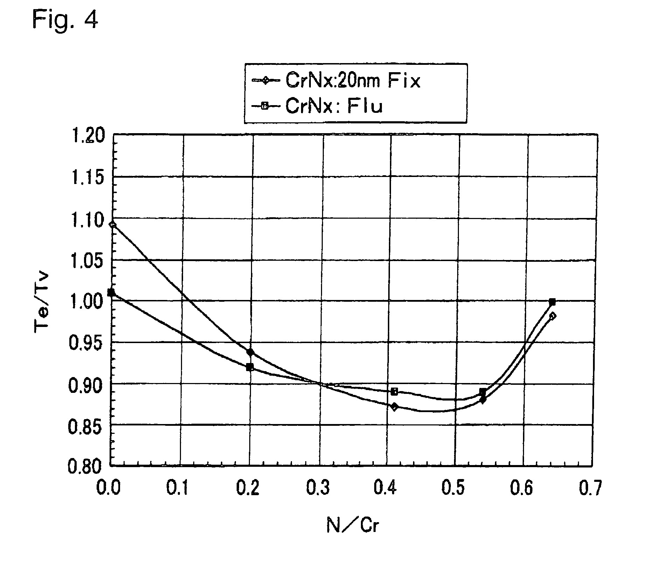

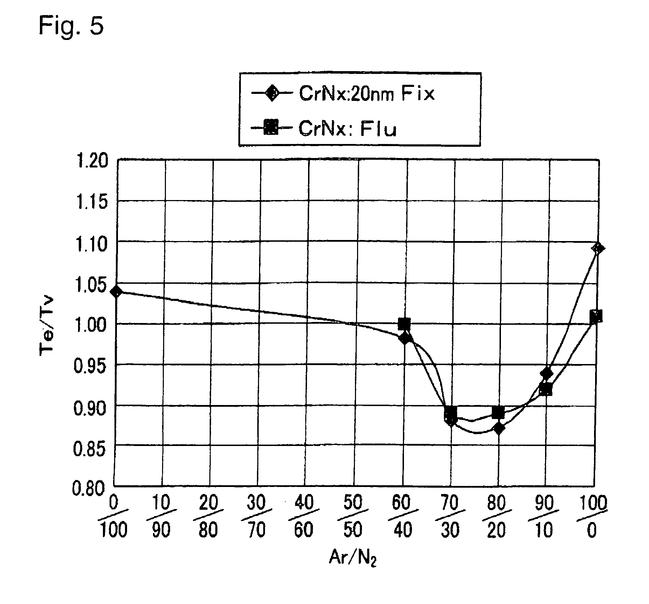

Fig. 4 is a graph showing a relation between the ratio of N atoms to chromium atoms (N/Cr) in a chromium nitride film and the solar transmittance Tₑ/visible light transmittance Tᵥ ratio. In the Fig, CrNx:20 nmFix represents a case where CrNx was fixed to be 20 nm, and CrNx:Flu represents a case where CrNx was fluctuated (calculated value). The same applies to Fig. 5.
Fig. 5 is a graph showing a relation between the ratio of inert gas (Ar gas) flow rate/N₂ gas flow rate and the solar transmittance Tₑ/visible light transmittance Tᵥ ratio.

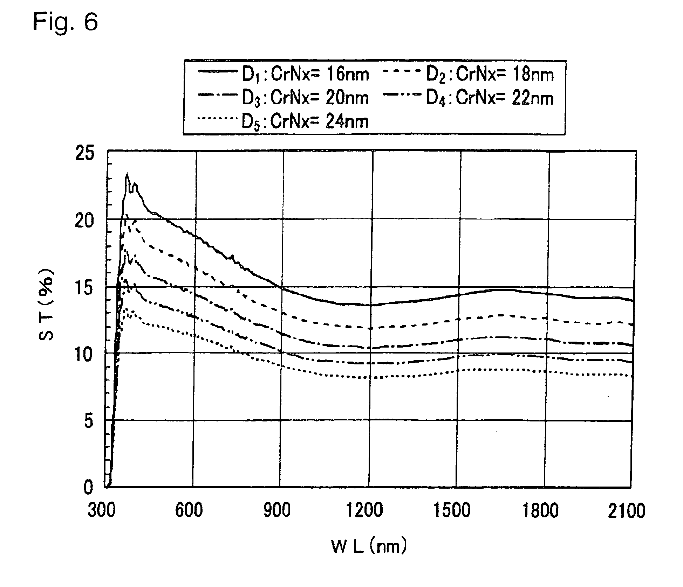

Fig. 6 is a graph showing spectra of spectral transmittances of samples wherein an oxygen-blocking undercoat film/a chromium nitride film having the thickness changed/an oxygen-blocking protective film are laminated on a glass substrate. The abscissa axis represents the wavelength (WL), and the ordinate axis represents the spectral transmittance (ST).

### MEANINGS OF SYMBOLS

10, 20: Heat reflecting glass
12: Glass substrate
14: Chromium nitride (CrNx) film
16: Oxygen-blocking undercoat film
17: Impurity-blocking undercoat film
18: Oxygen-blocking protective film

### BEST MODE FOR CARRYING OUT THE INVENTION

Now, the heat reflecting glass of the present invention and the process for producing the heat reflecting glass will be described in detail with reference to the preferred embodiments shown in the attached drawings.

Firstly, with reference to Figs. 1(a) and 1(b), schematic constructions will be described with respect to the heat reflecting glass of the present invention. Figs. 1 (a) and 1 (b) are schematic cross-sectional views illustrating the heat reflecting glass of the present invention, and Figs. 1(a) and 1(b) show different embodiments, respectively.
In Figs. 1(a) and 1(b) , thin film layers having the same constructions are represented by the same symbols. Each of Figs. 1 (a) and 1 (b) is an example of the heat reflecting glass which has, for example, a visible light transmittance Tᵥ of at most 35% and a solar transmittance Tₑ/visible light transmittance Tᵥ ratio of less than 1.0 and of which the optical properties undergo no substantial change even if heat treatment is applied for strengthening or bending and of which a heat reflecting film is made of chromium nitride, and which is increasingly demanded in recent years. Each of the heat reflecting glass 10 shown in Fig. 1(a) and the heat reflecting glass 20 shown in Fig. 1 (b) is one in such a state that no heat treatment has been applied for strengthening or bending.

Firstly, the embodiment shown in Fig.1 (a) will be described. The heat reflecting glass 10 shown in Fig. 1 (a) is such that on the surface of a glass substrate 12, an oxygen-blocking undercoat film 16 made of e.g. silicon nitride (SiNx, where x is a number; the details will be described hereinafter) is formed, and as an upper layer of this oxygen-blocking undercoat layer 16, a chromium nitride (CrNx where x is a number; the details will be described hereinafter) film 14 for heat reflection is formed. Further, in the heat reflecting glass 10, an oxygen-blocking protective film 18 made of e.g. silicon nitride (SiNx) is formed as an upper layer of the chromium nitride (CrNx) film 14 for heat reflection.

In the heat reflecting glass 10 shown in Fig. 1(a), the glass substrate 12 is, for example, soda lime glass (also called soda lime silica glass) as known float plate glass, being a glass having a thickness of 6 mm (hereinafter referred to as FL6).
Here, in the present invention, the type of the glass substrate 12 is not particularly limited, various glass plates such as a soda lime glass plate, a heat absorbing glass plate, etc. may be used, and the thickness is also not particularly limited.

In the heat reflecting glass 10, the oxygen-blocking undercoat film 16 and the oxygen-blocking protective film 18 are formed primarily to prevent penetration of oxygen into the chromium nitride film 14 for heat reflection. For example, in a case where a chromium nitride film 14 is formed directly on the surface of a glass substrate 12 without the oxygen-blocking undercoat film 16 and the oxygen-blocking protective film 18, if heat treatment (such as heat treatment at a temperature of from 500°C to 700°C) is applied for strengthening or bending without maintaining the atmosphere during the bending to be a non-oxidizing atmosphere, the balance of the optical properties and the thermal properties of the chromium nitride film 14 for heat reflection is likely to collapse (the transmittance tends to increase over the entire wavelength region of sunlight). That is, in a state where the oxygen-blocking undercoat film 16 and the oxygen-blocking protective film 18 are not present, especially when heat treatment is applied, oxygen penetrates into the chromium nitride (CrNx) film 14 for heat reflection. The oxygen-blocking undercoat film 16 and the oxygen-blocking protective film 18 are capable of preventing penetration of oxygen in the atmosphere into the chromium nitride film 14 for heat reflection thereby to prevent oxidation of the chromium nitride film 14 by the penetrated oxygen and to prevent collapse of the balance of the optical properties and the thermal properties, even when heat treatment is applied without keeping the atmosphere to be a non-oxidizing atmosphere during strengthening or bending.

In a case where the oxygen-blocking undercoat film 16 is made of silicon nitride (SiNx), such an oxygen-blocking undercoat film 16 may be formed on the surface of a glass substrate 12, for example, by disposing a glass substrate 12 having a clean surface in a vacuum chamber of a sputtering apparatus and carrying out sputtering by using a polycrystalline Si target as a sputtering target. At the time of forming the oxygen-blocking undercoat film 16, the interior of the vacuum chamber is firstly evacuated to e.g. 1.3×10⁻³ Pa, and nitrogen gas is supplied into the vacuum chamber e.g. at a gas flow rate of 100 sccm to bring the pressure in the vacuum chamber to be e.g. 6.0×10⁻¹ Pa. In such a state, reactive sputtering is carried out by applying an electric power of 2.00 kW by means of a DC pulse power source to form a film on the glass substrate.

In a case where the oxygen-blocking protective film 18 is made of silicon nitride (SiNx), also such an oxygen-blocking protective film 18 may be formed, for example, by disposing the glass substrate 12 in a state provided with the oxygen-blocking undercoat film 16 and the after-described chromium nitride film 14, in a vacuum chamber of a sputtering apparatus, and carrying out reactive sputtering under the same conditions as for the oxygen-blocking undercoat film 16. In the present invention, the method for forming the oxygen-blocking undercoat film or the oxygen-blocking protective film is not particularly limited, and depending upon the optical performance or oxygen-blocking performance required for the oxygen-blocking undercoat film or the oxygen-blocking protective film, various conditions in the sputtering may optionally be set. Further, the method for forming a thin film in order to form the oxygen-blocking undercoat film or the oxygen-blocking protective film is not particularly limited to the reactive sputtering, and various conventional methods such as a CVD (chemical vapor deposition) method may be employed.

The oxygen-blocking undercoat film 16 and the oxygen-blocking protective film 18 may be set to have a film thickness whereby it is possible to sufficiently prevent penetration of oxygen into the chromium nitride (CrNx) film 14 when heat treatment is applied. For example, the thickness of the oxygen-blocking undercoat film 16 is preferably from 5 to 20 nm, particularly preferably from 7 to 15 nm. The thickness of the oxygen-blocking protective film 18 is preferably from 10 to 30 nm, particularly preferably from 15 to 25 nm. SiNx has a relatively high refractive index as compared with the glass substrate, and if the oxygen-blocking undercoat film 16 or oxygen-blocking protective film 18 made of SiNx is thicker than necessary, it presents a substantial influence over the appearance of the heat reflecting glass 10. With respect to the oxygen-blocking undercoat film 16 and the oxygen-blocking protective film 18, it can be said that the film thickness should better be thick in order to block oxygen, and the film thickness should better be thin from the viewpoint of the appearance.

In this embodiment, the oxygen-blocking undercoat film and the oxygen-blocking protective film are described as films made of SiNx. However, in the present invention, the oxygen-blocking undercoat film and the oxygen-blocking protective film are, respectively, not limited to SiNx. In the present invention, the oxygen-blocking undercoat film and the oxygen-blocking protective film are required to be non-oxide films or films not completely oxidized and even if oxidized, they must be transparent films in a visible light region. The oxygen-blocking undercoat film and the oxygen-blocking protective film are film which prevent penetration of oxygen into the chromium nitride film when heated at the time of heat treatment and which will not discharge oxygen to the chromium nitride film even if the oxygen-blocking undercoat film itself or the oxygen-blocking protective film itself contains oxygen. Such oxygen-blocking undercoat film and oxygen-blocking protective film, even if oxidized, will remain transparent without absorption, with a mere change in the refractive index. Accordingly, they are preferably made of a material which presents no substantial influence over the optical properties after the heat treatment.

As examples of the oxygen-blocking undercoat film and the oxygen-blocking protective film, films containing, as the main component, at least one member selected from a nitride, a boronitride, a carbonitride and a silicon nitride may be mentioned as preferred examples. Particularly preferred may, for example, be a film containing, as its main component, a nitride of silicon or boron; or a film containing, as its main components, nitrides of at least two members selected from the group consisting of silicon, boron, aluminum, zirconium and tin (typical examples being a zirconium silicon nitride film, a tin silicon nitride film, etc.). Otherwise, it may be a film containing, as its main component, a partial oxide of the above-mentioned nitride, boronitride, carbonitride or silicon nitride. Among the forgoing, a film containing, as its main component, silicon nitride or zirconium silicon nitride is particularly good in the oxygen barrier performance and thus is most preferred. Here, "oxygen barrier performance" is a performance to prevent oxygen from penetrating into the chromium nitride film by passing through the oxygen-blocking undercoat film from the substrate side or through the oxygen-blocking protective film from the atmosphere side.

With respect to e.g. nitride films as the above-mentioned oxygen-blocking undercoat film and oxygen-blocking protective film, silicon nitride is represented by SiNx, where x represents a number. This means that the nitride may not necessarily be bonded in a stoichiometrically most common ratio, so long as it is transparent in a visible light region. For example, in the case of silicon nitride, Si₃N₄ is common, but in order to be transparent in a visible light region, the ratio of N to Si (corresponding to the above x) is preferably at least 1.25, particularly preferably at least 1.28.

The chromium nitride (CrNx, where x is a numerical value of 0<x<1) film 14 for heat reflection is **characterized in that** in the chromium nitride film, the ratio of the number of nitrogen atoms to the number of chromium atoms is from 20% to 60%, more preferably from 40% to 60%. Here, the ratio of the number of nitrogen atoms to the number of chromium atoms means (number of nitrogen atoms/number of chromium atoms)×100%, and by using (number of nitrogen atoms/number of chromium atoms)=x, the ratio of the number of nitrogen atoms to the number of chromium atoms may be represented by x×100%. In the heat reflecting glass 10 of this embodiment, with respect to the chromium nitride (CrNx) film 14 for heat reflection, by adjusting the ratio of the number of nitrogen atoms to the number of chromium atoms in the film to be from 20% to 60%, a heat reflecting glass is realized which has a visible light transmittance of at most 35% and a ratio of the solar transmittance to the visible light transmittance of less than 1.0.

Here, the visible light transmittance is a value defined in JIS R-3106 (1998). Further, the solar transmittance is a value defined in JIS R-3106 (1998). Specifically, the visible light transmittance can be obtained by multiplying the value of spectral transmittance of the object by weighting coefficients (coefficients set over the wavelength range of from 380 nm to 780 nm) obtained from the wavelength distribution of the CIE light-adapted relative luminocity and the CIE daylight D₆₅ spectrum, followed by obtaining a weighted average. Further, the solar transmittance can be obtained by multiplying the measured values of spectral transmittance of the object by weighting coefficients (coefficients set over the wavelength range of from 300 nm to 2,100 nm) representing a standard spectral distribution of sunlight, followed by obtaining a weighted average. Here, the weighting coefficients representing a standard spectral distribution of sunlight to be used for the calculation of the solar transmittance, are set to be particularly large values within the wavelength range of from about 1,000 nm to 1,300 nm as compared with other wavelength ranges. The solar transmittance may be said to well represent the degree of transmittance of heat rays particularly in a wavelength range of from 1,000 to 1,300 nm i.e. a near infrared region, of the sunlight.

The chromium nitride (CrNx) film 14 for heat reflection in the heat reflecting glass 10 of this embodiment, can be prepared by the following method. For example, a glass substrate 12 provided with an oxygen-blocking undercoat film 16 is disposed in a vacuum chamber of a sputtering apparatus, and the interior of the vacuum chamber is firstly evacuated to e.g. 1.3×10⁻³ Pa. Then, while supplying nitrogen gas (hereinafter nitrogen may be represented by N₂) at a flow rate of e.g. 20 sccm and argon gas (hereinafter argon may be represented by Ar) at a gas flow rate of e.g. 80 sccm into the vacuum chamber, the pressure in the vacuum chamber is controlled to be e.g. 6.0×10⁻¹ Pa. Under such a controlled state, using a DC pulse power source, an electric power of e.g. 2.00 kW is applied to form plasma in the reactor, and reactive sputtering is carried out by using a chromium target as the sputtering target, to form the film 14.

Here, Ar gas is taken as an example of the inert gas, but the inert gas may be other than Ar gas or may be a combination of a plurality of inert gases.

The flow rates (flow rates per unit time) of N₂ gas and Ar gas are, respectively, adjusted by mass flow controllers provided on the respective gas supply tubes connected to the chamber. The flow rate of each gas is represented by a volume stipulated for each gas (a volume stipulated under 1 atm (atmospheric pressure of 1,013 hPa) at 0°C) and may, for example, be represented by using a sccm (standard cc/min) unit. The Ar gas flow rate/N₂ gas flow rate corresponds to the Ar gas partial pressure/N₂ gas partial pressure in the chamber and thus corresponds to the number of atoms of Ar gas/the number of molecules of N₂ gas in the chamber. In this specification, the gas ratio will be represented by the Ar gas flow rate/N₂ gas flow rate or by (Ar gas:N₂ gas).

Heretofore, at the time of forming a chromium nitride film by reactive sputtering, it has been common to carry out reactive sputtering by using a chromium target in N₂ gas being 100%. The reason is such that with chromium nitride, it is desired to stabilize the optical constants (refractive index and extinction coefficient) of the film, but even if the N₂ gas ratio (such as the ratio of N₂ gas at the time of mixing Ar gas and N₂ gas) is the same, the nitriding degree (value x) of chromium nitride may change depending upon the influences of the apparatus (such as the position of the exhaust gas pump, and the position for introduction of the mixed gas), the electric power to be applied during sputtering, etc., and it was necessary to adjust it. In order to avoid such adjustment, it was common to carry out sputtering with a gas which consists of 100% of N₂.

In this embodiment, the ratio in the flow rate (the supply rate per unit time) of N₂ gas to Ar gas supplied into the reactor (vacuum chamber) at the time of preparing a chromium nitride (CrNx) film 14 by reactive sputtering, is adjusted to be (Ar gas:N₂ gas)=(70:30) to (90:10), so that the ratio of the number of nitrogen atoms to the number of chromium atoms in the chromium nitride (CrNx) film 14 will be from 20% to 60%. The ratio in the flow rate of Ar gas to N₂ gas is more preferably adjusted to be (Ar gas:N₂ gas)=(70:30) to (80:20). The ratio of the number of nitrogen atoms to the number of chromium atoms in the film at that time will be from about 40% to about. 60%.

As described above, the oxygen-blocking undercoat film 16 and the oxygen-blocking protective film 18 are set to have a film thickness whereby it is capable of sufficiently preventing oxygen from penetrating into the chromium nitride (CrNx) film 14 during the heat treatment. Accordingly, the heat reflecting glass 10 undergoes no substantial change in the optical properties even if the heat reflecting glass 10 is subjected to common heat treatment (e.g. heat treatment at a temperature of from 500°C to 700°C) for glass strengthening treatment or bending treatment. Further, the heat reflecting glass constructed by using a chromium nitride film 14 as a heat reflecting film also has good appearance. The heat reflecting glass 10 shown in Fig. 1 (a) as one embodiment of the present invention is a heat reflecting glass having a good appearance, which has a visible light transmittance Tᵥ of at most 35% and a solar transmittance Tₑ/visible light transmittance Tᵥ ratio of less than 1.0, preferably less than 0.9 and which undergoes no substantial change in the optical properties (the visible light transmittance Tᵥ, the solar transmittance Tₑ and the transmission color (the spectral curve shape)) even when heat treatment is applied for strengthening or bending.

The heat reflecting glass 20 shown in Fig. 1(b) is another embodiment of the heat reflecting glass of the present invention and is one to prevent oxygen or other impurities from penetrating into the chromium nitride film 14 for heat reflection, without impairing the appearance of the one in Fig. 1 (a) more than necessary. The heat reflecting glass 20 shown in Fig. 1 (b) is **characterized in that** as compared with the heat reflecting glass shown in Fig. 1(a), an impurity-blocking undercoat film 17 made of e.g. silicon dioxide (SiO₂) is provided between the glass substrate 12 and the oxygen-blocking undercoat film 16. The impurity-blocking undercoat film 17 blocks various impurities contained in the glass substrate 12, which penetrate from the glass substrate 12 towards the chromium nitride film 14 when heat treatment is applied for e.g. strengthening or bending. The method for forming the impurity-blocking undercoat film 17 is not particularly limited, and various known methods such as a CVD (chemical vapor deposition) method may be mentioned.

The glass substrate 12 being a float plate glass contains, as its main component, silicon dioxide (SiO₂) but also contains various impurities in a relatively large amount. Impurities contained in the glass substrate 12 substantially migrate particularly when heat treatment is applied. However, in the heat reflecting glass 20 shown in Fig. 1(b), even when heat treatment is applied, the impurity-blocking undercoat film 17 prevents migration of impurities such as sodium (Na) thereby to prevent the impurities from reaching the chromium nitride film 14. The impurity-blocking undercoat film 17 is a thin film made of the same component as silicon dioxide (SiO₂) being the main component of the glass substrate 12, and the optical properties such as the refractive index are substantially the same as the glass substrate 12 and present no substantial influence over the appearance of the heat reflecting glass 20. Here, silicon dioxide (SiO₂) contains oxygen atoms in a relatively large amount, but migration of such oxygen atoms is prevented by the oxygen-blocking undercoat film 16, whereby oxygen atoms in the impurity-blocking undercoat film 17 would not reach the chromium nitride film 14. The heat reflecting glass 20 shown in Fig. 1 (b) is also a heat reflecting glass having a good appearance, which has a visible light transmittance Tᵥ of at most 35% and a solar transmittance Tₑ/visible light transmittance Tᵥ ratio of less than 1.0 and which undergoes no substantial change in the optical properties even when heat treatment is applied for strengthening or bending.

In order to prevent impurities in the glass substrate 12 from reaching the chromium nitride film 14 without impairing the appearance of the heat reflecting glass more than necessary, it is preferred to construct the heat reflecting glass in the form as shown in Fig. 1 (b). In a case where it is unnecessary to consider the impurities contained in the glass substrate 12 (e.g. in a case where the glass substrate 12 contains substantially no impurities), the heat reflecting glass may be constructed simply to have the form as shown in Fig. 1 (a), whereby a balance of the optical properties and the thermal properties of the chromium nitride (CrNx) film 14 will not collapse even when heat treatment is applied for strengthening or bending.

Now, a heat reflecting glass as an example of the heat reflecting glass of the present invention will be described with reference to Examples and Test Examples.

### EXAMPLE 1

As Example 1, a heat reflecting glass corresponding to the first embodiment shown in Fig. 1 (a) was prepared. Specifically, in Example 1, an oxygen-blocking undercoat film made of silicon nitride (SiNx) was formed on a glass substrate (FL6) by reactive sputtering, and as laminated on the surface of the oxygen-blocking undercoat film, a chromium nitride film was formed by reactive sputtering. Further, as laminated on the surface of the chromium nitride film, an oxygen-blocking protective film made of silicon nitride was formed.

The conditions at the time of forming the oxygen-blocking undercoat film and the oxygen-blocking protective film made of silicon nitride (SiNx), were as follows.
Sputtering target: Polycrystalline Si target having a size of 130 mm × 430 mm N₂ gas flow rate during sputtering: 100 sccm
Pressure in the chamber during sputtering: 5.1×10⁻¹ Pa
Plasma-forming electric power: 2.00 kW as electric power supplied from a DC pulse power source

Here, SiNx is usually Si₃N₄ and may include also a material having a composition wherein the ratio of N to Si is slightly different.

Further, the conditions at the time of forming the chromium nitride film were as follows.
Sputtering target: Chromium target having a size of 130 mm × 430 mm
Ar gas flow rate during sputtering: 80 sccm
N₂ gas flow rate during sputtering: 20 sccm
Pressure in the chamber during sputtering: 6.0×10⁻¹ Pa
Plasma-forming electric power: 2.00 kW as electric power supplied from a DC pulse power source

With respect to the heat reflecting glass in Example 1, at the time of preparing the chromium nitride film by reactive sputtering, the above-mentioned Ar gas flow rate/N₂ gas flow rate, supplied into the reactor (vacuum chamber) was adjusted to be 4.0. In the chromium nitride film 14 formed under such condition, the ratio (N/Cr) of the number of nitrogen atoms to the number of chromium atoms was about 41 %.

Here, the ratio (N/Cr) of nitrogen atoms to chromium atoms was obtained by subjecting the formed chromium nitride film to XPS (X-ray photoelectron spectroscopy). In Example 1, as the XPS apparatus, Quantera SXM apparatus, manufactured by PHI (Physical Electronics Inc.) was used. By using this apparatus, the ratio (N/Cr) of nitrogen atoms to chromium atoms was measured under the following measuring conditions.
X-ray source: Al monochromated, Kα, 1486. 7 (eV), 25W
Detect angle : 45 (deg)
Pass energy: 224.0 (eV)
eV/step: 0.4 (eV)
Sputtering condition: Ar gas 2 (kV), 3×3 (mm²), 3 (min)

Here, the above sputtering condition is to remove a contaminated layer on the surface.

The ratio (N/Cr) of nitrogen atoms to chromium atoms in Example 1 is a value obtained by determining the ratio (N/Cr) of nitrogen atoms to chromium atoms from an emitted photoelectron spectrum obtained by such measurement by using a software attached to the XPS apparatus. Specifically, N/Cr was calculated on such a basis that the spectral amount within a range of from 565 to 600 (eV) corresponding to the 2p peak of Cr atoms corresponds to the Cr amount, and the spectral amount within a range of from 392 to 407 (eV) corresponding to the 1 s peak of nitrogen atoms corresponds to the N amount.

Here, at the time of the calculation by the software attached to the XPS apparatus, as relative sensitivity coefficients, coefficients of the 2p peak of Cr atoms: 0.860 and the 1s peak of nitrogen atoms: 0.499, were used, and the amounts of chromium atoms and nitrogen atoms were obtained from the values measured by the XPS apparatus.

Further, in Example 1, the thickness of the chromium nitride film was 21 nm, and the oxygen-blocking undercoat film was 10 nm and the oxygen-blocking protective film was 20 nm. For the thickness of each layer, a film deposition rate is preliminarily obtained from the film deposition time and the film thickness by means of a stylus film thickness meter, and the film thickness of each layer is a value estimated from such a film deposition rate and film deposition time. The film thickness (21 nm) of the chromium nitride film is a film thickness which is preliminarily set so that the visible light transmittance Tᵥ will be about 14.0% in such a state that the oxygen-blocking undercoat film is 10 nm and the oxygen-blocking protective film is 20 nm.

Table 1 is a table which summarizes the values of the solar transmittance Tₑ and the visible light transmittance Tᵥ measured under the measuring conditions stipulated in the above-identified JIS, and the solar transmittance Tₑ/visible light transmittance Tᵥ ratio. Table 1 also shows the measured values of the visible light transmittance Tᵥ' and the solar transmittance Tₑ' in a state after the heat treatment was applied to the heat reflecting glass in Example 1, and the solar transmittance Tₑ'/visible light transmittance Tᵥ' value. Here, the conditions for the heat treatment were 650°C (the atmosphere temperature in the furnace) and 15 minutes in accordance with common heating conditions (500°C to 700°C) employed in glass strengthening treatment or bending treatment.

**TABLE 1**

| | | | |
|---|---|---|---|
| Before heat treatment | Solar transmittance Tₑ | Visible light transmittance Tᵥ | Tₑ/Tᵥ |
| | 12.2 | 14.4 | 0.87 |
| After heat treatment | Solar transmittance Tₑ' | Visible light transmittance Tᵥ' | Tₑ'/Tₑ' |
| | 12.7 | 14.2 | 0.89 |

As shown in Table 1, the heat reflecting glass in Example 1 underwent no substantial change in the optical properties even when heat treatment was applied for strengthening or bending. Both before the heat treatment and after the heat treatment, the heat reflecting glass in Example 1 satisfies the properties required for a heat reflecting glass for which the demand is increasing in recent years, for example, such properties as a visible light transmittance Tᵥ of at most 35%, and a solar transmittance Tₑ/visible light transmittance Tᵥ ratio of less than 1.0.

### EXAMPLE 2

Firstly, the optical performance of a single chromium nitride (CrNx) film was examined as a Reference Example.

Fig. 2 is an example of results of tests carried out by the present inventors and shows spectra of spectral transmittances of a plurality of samples A₁ to A₅ constructed by preparing a single chromium nitride (CrNx) film on a glass substrate under respectively different film-deposition conditions. Each of the plurality of samples A₁ to A₅ is a sample obtained by preparing a chromium nitride film on the surface of a clean glass substrate (FL6) by a reactive sputtering method.

Each of chromium nitride (CrNx) single film samples A₁ to A₅ is a sample prepared in such a manner that a glass plate is disposed in a reactor (vacuum chamber) and sputtering is carried out by using a chromium (Cr) target as a sputtering target while the interior of the vacuum chamber is controlled to be a N₂ gas-containing atmosphere, to form a chromium nitride film for heat reflection on the surface of the glass substrate. The respective samples A₁ to A₅ are ones wherein the ratio Ar/N₂ of the flow rate of Ar gas to the flow rate of N₂ gas supplied to the vacuum chamber during the reactive sputtering is changed. Not only in Fig. 2, but also in Figs. 3 and 5 which will be described hereinafter, the ratio of the flow rate of Ar gas to the flow rate of N₂ gas is represented by Ar/N₂.

In the preparation of the plurality of samples A₁ to A₅, the conditions for forming the chromium nitride films other than the ratio of the flow rate of Ar gas to the flow rate of N₂ gas, were as follows.
Sputtering target: Chromium target having a size of 130 mm × 430 mm
Total flow rate of gas during sputtering (Ar gas flow rate+N₂ gas flow rate): 100 sccm
Pressure in the chamber during sputtering: 6.0×10⁻¹ Pa
Plasma-forming electric power: 2.00 kW as electric power supplied from a DC pulse power source

Further, the film thickness of the chromium nitride film of each of samples A₁ to A₅ was set so that by the film deposition rate and the film deposition time preliminarily obtained, the thickness of the chromium nitride film of each of samples A₁ to A₅ became about 20 nm.

At the time of forming each of samples A₁ to A₅, the Ar gas flow rate/N₂ gas flow rate ratio was adjusted to be one identified in the graph shown in Fig. 2. Samples A₁ and A₂ are samples prepared by reactive sputtering in accordance with conventional cases i.e. gas ratio (Ar gas:N₂ gas)=(0:100) or (60:40) (hereinafter the gas ratio may be represented also as Ar:N₂)).
Table 2 is a table summarizing the gas ratio and the ratio (N/Cr) in the number of nitrogen atoms to chromium atoms, at the time of forming a chromium nitride film, corresponding to each of samples A₁ to A₅. Further, in Table 2 and in Fig. 2, in addition to samples A₁ to A₅, new sample A₆ is also shown. Sample A₆ is a sample obtained by forming a chromium nitride film at an Ar gas flow rate/N₂ gas flow rate ratio being (Ar:N₂)=(100:0) i.e. without supplying N₂ gas (provided that (N/Cr)=0). The ratio (N/Cr) in the number of atoms of nitrogen to chromium in Tables 2 and 3, is a value obtained by using the same measuring method and conditions as the measuring method and conditions employing the XPS apparatus as described in the above Example 1.

**TABLE 2**

| Sample | Gas ratio during film deposition (Ar:N₂) | Ratio in the number of atoms of nitrogen to chromium (N/Cr) |
|---|---|---|
| A₁ | (0:100) | - |
| A₂ | (60:40) | 0.64 |
| A₃ | (70:30) | 0.54 |
| A₄ | (80:20) | 0.41 |
| A₅ | (90:10) | 0.20 |
| A₆ | (100:0) | 0.00 |

As shown in Fig. 2, spectra of the spectral transmittances of the respective chromium nitride single films are different from one another among the respective samples A₂ to A₆. When the tendency of the spectra of the spectral transmittances is specifically observed, it is evident that as the ratio (N/Cr) of nitrogen atoms to chromium atoms becomes small, the spectral transmittance tends to be low in the order of samples A₁ to A₅ over the entire wavelength region (specifically from 300 nm to 2,100 nm).

Then, as an Example, a construction having the above chromium nitride film sandwiched by silicon nitride (SiNx) was formed. That is, by reactive sputtering, an oxygen-blocking undercoat film (10 nm) made of silicon nitride (SiNx) was formed on a glass substrate (FL6), and as laminated on the surface of the oxygen-blocking undercoat film, a chromium nitride film (20 nm) was formed by reactive sputtering by changing the Ar gas flow rate/N₂ gas flow rate ratio in the sputtering gas. Further, as laminated on the surface of the chromium nitride film, an oxygen-blocking protective film (20 nm) made of silicon nitride was formed.

The conditions at the time of forming the oxygen-blocking undercoat film and the oxygen-blocking protective film made of silicon nitride (SiNx) were as follows.
Sputtering target: Polycrystalline Si target having a size of 130 mm × 430 mm
N₂ gas flow rate during sputtering: 100 sccm
Pressure in the chamber during sputtering: 5.1×10⁻¹ Pa
Plasma-forming electric power: 2.00 kW as electric power supplied from a DC pulse power source

Fig. 3 shows spectral transmittances of the constructions (samples B₁ to B₆) wherein a chromium nitride film having the Ar gas flow rate/N₂ gas flow rate ratio changed was sandwiched by silicon nitride (SiNx). Further, Table 3 shows their physical property values.

In the case of samples B₁ and B₂ as Comparative Examples, as compared with the spectral transmittance in the visible light region, the spectral transmittance on the longer wavelength side than the visible light region is large as a whole. As compared with samples B₁ and B₂, in the case of samples B₃ to B₅ of the present invention, the spectral transmittance in the visible light region and the spectral transmittance on the longer wavelength side than the visible light region are substantially equal as a whole. However, when attention is drawn to the near infrared region (the wavelength range of from about 1,000 nm to 1,300 nm) in the wavelength region on a longer wavelength side, particularly in the case of samples B₃ and B₄, the spectral transmittance in the near infrared region is remarkably low as compared with the spectral transmittance in the visible light region. In the case of B₆ as a Comparative Example, the transmittance in a visible light region is lower than in the near infrared region.

With respect to these samples B₃ to B₅, the optical properties after heat treatment are not confirmed. However, sample B₄ is substantially equal to the sample in Example 1, and it is considered that the optical properties after heat treatment of B₃ to B₅ are free from a change in the optical property (Tₑ/Tᵥ) like in Example 1.

As mentioned above, it can be said that the visible light transmittance Tᵥ defined in the above JIS well reflects the degree of the spectral transmittance in the visible light region (wavelength range of from 380 nm to 780 mm), and the solar transmittance as defined in the same JIS well reflects the degree of the spectral transmittance in the near infrared region (wavelength range of from 1,000 nm to 1,300 nm). When the solar transmittance Tₑ/visible light transmittance Tᵥ ratio is obtained, as compared with samples B₁ and B₂ as Comparative Examples, samples B₃ to B₅ show relatively small values of the solar transmittance Tₑ/visible light transmittance Tᵥ ratio, and particularly in the case of samples B₃ and B₄, such a ratio becomes less than 0.9.

**TABLE 3**

| Sample | Ar/N₂ ratio (Ar:N₂) | N/Cr | Tₑ | Tᵥ | Tₑ/Tᵥ | CrNx film thickness |
|---|---|---|---|---|---|---|
| B₁ | (0:100) | - | 23.2 | 22.3 | 1.04 | |
| B₂ | (60:40) | 0.64 | 21.2 | 21.6 | 0.98 | 20 nm |
| B₃ | (70:30) | 0.54 | 15.1 | 17.1 | 0.88 | 20 nm |
| B₄ | (80:20) | 0.41 | 12.9 | 14.8 | 0.87 | 20 nm |
| B₅ | (90:10) | 0.20 | 8.1 | 8.6 | 0.94 | 20 nm |
| B₆ | (100:0) | 0.00 | 10.4 | 9.5 | 1.09 | 20 nm |

Calculated values by a simulation are shown in Table 4 wherein the solar transmittance Tₑ/visible light transmittance Tᵥ ratio is obtained under such a condition that the visible light transmittance Tᵥ becomes constant (14%). In order to adjust the visible light transmittance Tᵥ to be constant (14%), the thickness of the chromium nitride film was changed, and the thicknesses of the oxygen-blocking undercoat film (10 nm) made of silicon nitride and the oxygen-blocking protective film (20 nm) made of silicon nitride were fixed.

Each of samples C₁ to C₆ shown in Table 4 is assumed to be a heat reflecting glass having the same construction as the heat reflecting glass 10 shown in Fig. 1(a) and shows values obtained by calculating the solar transmittance Tₑ and the visible light transmittance Tᵥ stipulated in the above-mentioned JIS by using the actually measured values of the spectral transmittances shown in Fig. 2, the spectral transmittances of known SiNx films (oxygen-blocking undercoat film and oxygen-blocking protective film) and the spectral transmittance of a known glass substrate. Further, the calculated values for sample C₄ are values obtained by simulation (calculation) under the same film thickness and gas ratio conditions as the heat reflecting glass measured in the above Example 1. Samples C₃ to C₅ represent Examples of the present invention.

**TABLE 4**

| Sample | Ar/N₂ ratio (Ar:N₂) | N/Cr | Tₑ (calculated) | Tᵥ (calculated) | Tₑ/Tᵥ (calculated) | CrNx film thickness (calculated) |
|---|---|---|---|---|---|---|
| C₁ | (0:100) | - | | | | |
| C₂ | (60:40) | 0.64 | 14.0 | 14.0 | 1.00 | 31 nm |
| C₃ | (70:30) | 0.54 | 12.4 | 14.0 | 0.89 | 24 nm |
| C₄ | (80:20) | 0.41 | 12.7 | 14.0 | 0.89 | 21 nm |
| C₅ | (90:10) | 0.20 | 12.9 | 14.0 | 0.92 | 14 nm |
| C₆ | (100:0) | 0.00 | 14.2 | 14.0 | 1.01 | 16 nm |

The results in Tables 3 and 4 are shown in Figs. 4 and 5. In Fig. 4, when the ratio (N/Cr) of the number of nitrogen atoms to the number of chromium atoms in the chromium nitride film is from 20% to 60% (from 0.2 to 0.6 in the graph), the solar transmittance Tₑ/visible light transmittance Tᵥ ratio is not more than 0.95. Further, within such range, fluctuation in the solar transmittance Tₑ/visible light transmittance Tᵥ ratio is little, and thus it was found that the solar transmittance Tₑ/visible light transmittance Tᵥ is stable to fluctuation in the ratio (N/Cr) of the number of nitrogen atoms to the number of chromium atoms.

Further, in Fig. 5, when the ratio in the flow rate (the flow-in amount per unit time) of Ar gas to N₂ gas is (Ar:N₂)=(70:30) to (90:10), the solar transmittance Tₑ/visible light transmittance Tᵥ ratio is not more than 0.95. Further, within this range, fluctuation in the solar transmittance Tₑ/visible light transmittance Tᵥ ratio is little, and it was found that the solar transmittance Tₑ/visible light transmittance Tᵥ ratio is stable to fluctuation in the flow rate of Ar gas to N₂ gas.

From these results, it was found that when the ratio (N/Cr) of the number of nitrogen atoms to the number of chromium atoms is adjusted to be from 20% to 60%, or reactive sputtering is carried out to form a chromium nitride film at a ratio of (Ar:N₂)=(70:30) to (90:10), it is possible to obtain a heat reflecting glass having such a performance that the visible light transmittance Tᵥ is at most 35% and the transmittance Tₑ/visible light transmittance Tᵥ ratio is less than 1.0 and it is possible to reduce fluctuation in the solar transmittance Tₑ/visible light transmittance Tᵥ ratio against fluctuation in the conditions for film deposition of the chromium nitride film.

### EXAMPLE 3

Further, Fig. 6 shows the spectra of spectral transmittances of a plurality of samples D₁ to D₅ which were, respectively, formed by changing the film thickness of a chromium nitride film (CrNx) under a gas flow rate condition of (Ar:N₂)=(80:20). Each of samples D₁ to D₅ is different only in the film thickness of each chromium nitride film (CrNx) from the film deposition conditions for sample C₄. That is, each of samples D₁ to D₅ shown in Fig. 6 is prepared by setting the Ar gas flow rate/N₂ gas flow rate to be (Ar:N₂)=(80:20) and has a ratio in the number of atoms (N/Cr) in the chromium nitride film being 0.41. Further, the film thickness shown in the graph in Fig. 6 was obtained by a film deposition time preliminarily calculated from the measured value by using the preliminarily obtained film deposition rate.

As shown in Fig. 6, in a case where the ratio of nitrogen atoms to chromium atoms (N/Cr) in the chromium nitride film is substantially equal, even if the thickness of the chromium nitride film is different, the general tendency of the spectral transmittance does not particularly change. In the chromium nitride film, the solar transmittance Tₑ/visible light transmittance Tᵥ ratio is determined by the ratio of N₂ atoms to chromium atoms (N/Cr) in the chromium nitride film, or by the Ar gas flow rate/N₂ gas flow rate ratio in the reactive sputtering, and the film thickness does not contribute. In other words, simply by changing the film thickness of the chromium nitride film, it is possible to lower overall spectra of spectral transmittances and it is possible to reduce the absolute value of the visible light transmittance or the absolute value of the solar transmittance. However, merely by changing the thickness of the chromium nitride film, it is not possible to adjust the ratio of the solar transmittance to the visible light transmittance. The present inventors have had such a finding for the first time and have arrived at the present invention. Table 5 shows the physical property values obtained from the spectral transmittance values shown in Table 6. The solar transmittance Tₑ/visible light transmittance Tᵥ ratio is the same even when the film thickness of the chromium nitride film changes. Samples D₁ to D₅ have a visible light transmittance Tᵥ within a range of from about 10% to about 20%, which is sufficient to prevent glare felt by a person in a room in e.g. a building or sufficient for a privacy nature not being seen from outside, and the solar transmittance Tₑ/visible light transmittance Tᵥ ratio is as low as 0.87, which is effective to prevent heat from entering into the room.

**TABLE 5**

| Sample | Ar:N₂ ratio | N/Cr | CrNx film thickness | Tₑ | Tᵥ | Tₑ/Tᵥ |
|---|---|---|---|---|---|---|
| D₁ | 80:20 | 0.41 | 16 nm | 16.8 | 19.2 | 0.87 |
| D₂ | ↑ | ↑ | 18 nm | 14.7 | 14.7 | 0.87 |
| D₃ | ↑ | ↑ | 20 nm | 12.9 | 12.9 | 0.87 |
| D₄ | ↑ | ↑ | 22 nm | 11.4 | 11.4 | 0.87 |
| D₅ | ↑ | ↑ | 24 nm | 10.1 | 10.1 | 0.87 |

In the heat reflecting glass of the present invention, the construction of layers formed on the glass substrate is not limited to the embodiments in the above Examples. For example, in order to prevent, with higher precision, oxygen from entering into the chromium nitride film for heat reflection, a second protective film may further be provided as an upper layer of the oxygen-blocking protective film as the topmost layer in the embodiment shown in Fig. 1. The second protective film may, for example, be a film made of a metal oxide and being transparent in a visible light region, which preferably has a high oxygen-barrier property. Specifically, tin oxide, tantalum oxide, niobium oxide, titanium oxide, silicon oxide, zirconium oxide or zinc oxide may, for example, be mentioned. The thickness of such a second protective film may be determined in consideration of the oxygen-blocking performance or optical properties, which a heat reflecting glass should have. Further, a layer other than such a second protective film may be provided as the case requires.

In the foregoing, the heat reflecting glass of the present invention and the process for producing such a heat reflecting glass have been described in detail. However, it should be understood that the present invention is by no means restricted to the above embodiments or examples and may include various modifications and changes within a range not departing from the concept of the present invention.

### INDUSTRIAL APPLICABILITY

The heat reflecting glass of the present invention is excellent in the solar heat-blocking performance and undergoes no substantial change in the optical performance even when subjected to strengthening treatment or bending treatment, and thus, it is useful for a glass window for buildings or vehicles and is widely useful also for mobile means other than vehicles, such as aircraft or trains.

The entire disclosure of Japanese Patent Application No. 2007-336133 filed on December 27, 2007 including specification, claims, drawings and summary is incorporated herein by reference in its entirety.

## Claims

1. A heat reflecting glass comprising a glass substrate, and an oxygen-blocking undercoat film, a chromium nitride film and an oxygen-blocking protective film formed in this order on the glass substrate, wherein in the chromium nitride film, the ratio in the number of atoms of nitrogen to chromium (i.e. the number of nitrogen atoms/the number of chromium atoms) is from 20% to 60%.

2. The heat reflecting glass according to Claim 1, wherein each of the oxygen-blocking undercoat film and the oxygen-blocking protective film, is a film containing, as the main component, a nitride of silicon or boron, or a film containing, as the main components, nitrides of at least two elements selected from the group consisting of silicon, boron, aluminum, zirconium and tin.

3. The heat reflecting glass according to Claim 1 or 2, which has a visible light transmittance of at most 35% as defined in JIS R-3106 (1998) and a ratio of its solar transmittance as defined in JIS R-3106 (1998) to the visible light transmittance (i.e. the solar transmittance/the visible light transmittance) of less than 1.0.

4. The heat reflecting glass according to any one of Claims 1 to 3, which has been subjected to heat treatment at a temperature of at least 500°C.

5. The heat reflecting glass according to any one of Claims 1 to 4, wherein the film thickness of the oxygen-blocking undercoat film is from 5 to 20nm.

6. The heat reflecting glass according to any one of Claims 1 to 5, wherein the film thickness of the oxygen-blocking protective film is from 10 to 30nm.

7. The heat reflecting glass according to any one of Claims 1 to 6, which has an impurity-blocking undercoat film to prevent migration of impurities contained in the glass substrate, between the glass substrate and the oxygen-blocking undercoat film.

8. A process for producing a heat reflecting glass comprising a glass substrate, and an oxygen-blocking undercoat film, a chromium nitride film and an oxygen-blocking protective film formed in this order on the glass substrate, which comprises:
a step of introducing a glass substrate into a film deposition chamber, and sputtering a chromium target in a nitrogen-containing atmosphere in the chamber to form a chromium nitride film on the glass substrate, and
a step of supplying not only nitrogen gas but also an inert gas other than the nitrogen gas into the chamber during the sputtering, and adjusting the ratio of the amount of the inert gas supplied to be within a range of (the inert gas:the nitrogen gas)=(70:30) to (90:10).

9. The process for producing a heat reflecting glass according to Claim 8, which has:
a step of forming, prior to the sputtering, an oxygen-blocking undercoat film being a film containing, as the main component, a nitride of silicon or boron, or a film containing, as the main components, nitrides of at least two elements selected from the group consisting of silicon, boron, aluminum, zirconium and tin, on the glass substrate, and
a step of forming, after the sputtering, an oxygen-blocking protective film being a film containing, as the main component, a nitride of silicon or boron, or a film containing, as the main components, nitrides of at least two elements selected from the group consisting of silicon, boron, aluminum, zirconium and tin, on the surface of the chromium nitride film.

10. The process for producing a heat reflecting glass according to Claim 8 or 9, which includes heat treatment at a temperature of at least 500°C after forming the oxygen-blocking undercoat film, the chromium nitride film and the oxygen-blocking protective film.
